Europäisches Patentamt

European Patent Office

Office européen des brevets

(19)

(11) Publication number: **0 153 703**
**A2**

(12) # EUROPEAN PATENT APPLICATION

(21) Application number: **85101900.0**

(22) Date of filing: **21.02.85**

(51) Int. Cl.⁴: **G 01 N 24/08**

(30) Priority: **24.02.84 JP 32309/84**

(43) Date of publication of application:
**04.09.85 Bulletin 85/36**

(84) Designated Contracting States:
**DE FR GB NL**

(71) Applicant: **HITACHI, LTD.**
**6, Kanda Surugadai 4-chome Chiyoda-ku**
**Tokyo 100(JP)**

(72) Inventor: **Matsui, Shigeru**
**203, 2-17-9, Maehara-cho**
**Koganei-shi Tokyo(JP)**

(72) Inventor: **Kuroda, Masao**
**1B202 3-296, Shimatsudo**
**Matsudo-shi Chiba-ken(JP)**

(72) Inventor: **Yamamoto, Etsuji**
**E403, 2-32, Koyasu-cho**
**Hachioji-shi Tokyo(JP)**

(72) Inventor: **Shiono, Hidemi**
**2516-1, Kusabana**
**Akikawa-shi Tokyo(JP)**

(72) Inventor: **Kohno, Hideki**
**4-10-23-305, Takaido-higashi**
**Suginami-ku Tokyo(JP)**

(74) Representative: **Strehl, Schübel-Hopf, Schulz**
**Widenmayerstrasse 17 Postfach 22 03 45**
**D-8000 München 22(DE)**

(54) **NMR imaging apparatus.**

(57) In an NMR imaging apparatus, a series of sequences each including the excitation and measurement of nuclear spins and wait for awaiting the growth of the nuclear spins in the direction of a magnetostatic field are repeatedly performed so as to image the spin density distribution etc. of an object (91) in two dimensions. The apparatus comprises sequence control means (1-2) to apply an RF magnetic-field pulse and gradient magnetic-field pulses for rendering the phases of the nuclear spins of the object uniform after the measurement of the nuclear spins and to subsequently apply an RF magnetic-field pulse for flipping back the nuclear spins of the uniform phases into the sense of the magnetostatic field.

*FIG. 1*

Title of the Invention

NMR Imaging Apparatus

Background of the Invention

The present invention relates to NMR imaging apparatuses, and more particularly to an NMR imaging apparatus well-suited for remarkably shortening a scan time as compared with that of a prior art.

Various apparatuses for obtaining images corresponding to the spatial distributions of spin densities or relaxation times of an object distributed in three dimensions have been proposed, and have led to the stage of practical use.

Those of imaging methods hitherto proposed which have succeeded in producing images of high quality are the two of a projection-reconstruction method and a direct Fourier transformation method. In a typical method of the former, only the nuclear spins of a specified slice or thin plane are excited by selective excitation (for example, P. Mansfield et al., "Medical Imaging by NMR", British Journal of Radiology 50, pp. 188 – 194 (1977)), and a magnetic field gradient is subsequently applied in a predetermined direction so as to measure a spin signal projected in a direction perpendicular to the direction of the gradient. The measurement is repeated while the direction of the magnetic field gradient is being changed, thereby to obtain data. The spin
distribution within the slice plane is reconstructed
by inversely projecting the obtained data. Typical
as the latter are the applications of a Fourier Zeugmatography
method proposed by A. Kumar et al. (Journal of Magnetic
Resonance 13, pp. 69 - 83, 1975) and a spin-warp method
proposed by W. A. Edelstain et al. (Physics in Medicine
& Biology 25, pp. 751 - 756, 1980). In both of them,
the nuclear spins of a specified slice plane are excited
by selective excitation, and before a spin signal is
measured with a magnetic field gradient ($G_Y$) applied
in a predetermined direction, the positional information
of X-coordinate is phase-encoded in the signal by a
magnetic field gradient ($G_X$) orthogonal to the first-
mentioned magnetic field gradient ($G_Y$). A plurality
of times of measurements are performed while the magnitude
of the phase encoding is being changed, and obtained
data are subjected to two-dimensional Fourier transformation
so as to effect imaging.

    With any of these methods, a plurality of times
of spin excitations and measurements are required for
obtaining a two-dimensional image. When one time of
spin excitation and measurement have ended, the growth
of magnetization vectors in the direction of a magnetostatic
field is awaited, and then, the next time of spin excitation and measurement are carried out. Although the wait time in this case depends upon the longitudinal relaxation time $T_1$ of the object, it is usually several hundred milliseconds to about one second. This wait time accounts for the greater part of a period of time necessary for the imaging.

## Summary of the Invention

An object of the present invention is to provide a new measurement method and measurement apparatus capable of producing an NMR image of high resolution and excellent image quality in a much shorter time than in a prior art by the use of a spin flip-back method.

With note taken of the fact that the decay of a signal in NMR imaging is not an irreversible process, the present invention consists in that after a signal has been measured once, a spin system is irradiated with a 180° pulse to invert the time variation of the spin system thereby to create the decayed signal again, and that the created signal is forcibly flipped back in the direction of a magnetostatic field by a 90° pulse, whereby a wait time till the next measurement is shortened to realize high-speed scan.

- 4 -

Brief Description of the Drawings

Fig. 1 is a block diagram showing the arrangement of an embodiment of the present invention.

Figs. 2A - 2E are time charts showing the pulse sequence of a measurement in an example of the present invention.

Figs. 3A - 3K are diagrams for explaining the operations of the pulse sequence in Figs. 2A - 2E.

Description of the Preferred Embodiments

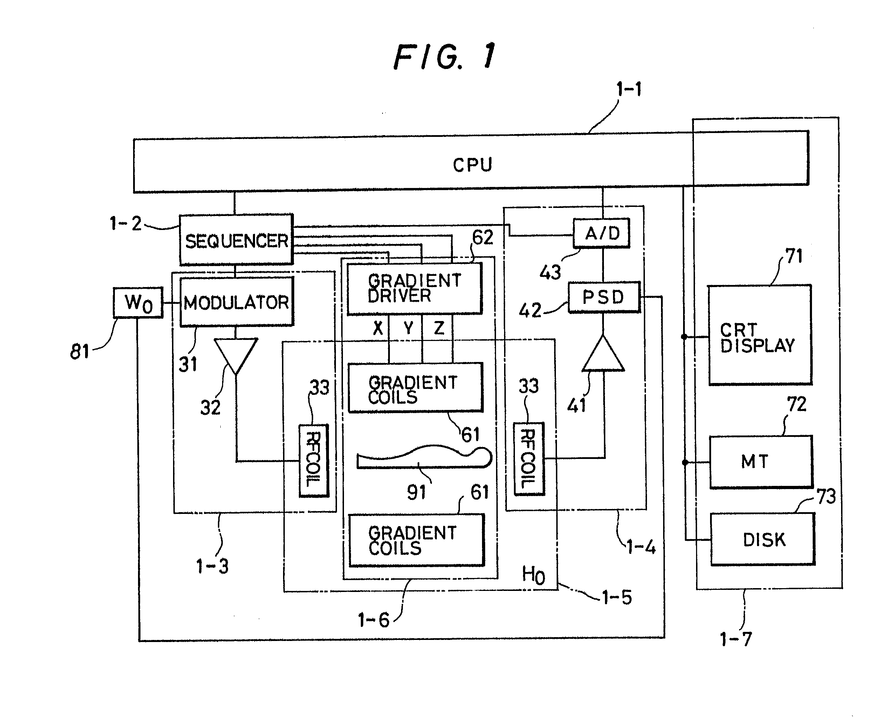

Now, the construction and operation of an embodiment of the present invention will be described. Fig. 1 shows a block diagram of the present apparatus. The apparatus operates under the control of a CPU 1-1, and is broadly divided into a sequencer 1-2, a transmitting unit 1-3, a receiving unit 1-4, a magnetostatic field generating magnet 1-5, a magnetic field gradient generating unit 1-6 and a signal processing unit 1-7. The sequencer 1-2 sends the respective units various instructions necessary for the system of the present invention. The transmitting unit 1-3 includes a modulator 31 and an RF amplifier 32. In the modulator 31, RF pulses whose phase and envelope are designated by the sequencer 1-2 are formed using a reference RF signal which is sent from a reference RF signal generator 81. The RF pulses are supplied to an RF coil 33 through the RF amplifier 32. Thus,

- 5 -

0153703

RF magnetic field pulses are impressed on a nuclear spin system, namely, an object 91 in accordance with a predetermined sequence. The receiving unit 1-4 includes a receiving RF amplifier 41, a detector 42 and an A/D converter 43. Response signals from the nuclear spin system received by the RF coil 33 are detected by phase-sensitive detection by means of the detector 42, and are converted by the A/D converter 43 into digital signals at a sampling rate of predetermined period. Data put into the digital signals are sent to the signal processing unit 1-7. Meanwhile, the magnetostatic field generating unit 1-5 is made up of a magnet or a coil through which a fixed direct current is caused to flow, and it applies a fixed magnetostatic field $H_o$ to the nuclear spin system. Besides, the magnetic field gradient generating unit 1-6 includes gradient coils 61 which are wound with three directions X, Y and Z as axes, and a driver 62 which drives the respective coils. Pulse currents of timings and shapes designated by the sequencer 1-2 are caused to flow through the respective gradient coils of the axes X, Y and Z, whereby gradient magnetic-field pulses $G_X$, $G_Y$ and $G_Z$ in the respective directions X, Y and Z are impressed on the nuclear spin system. The signal processing unit 1-7 includes the CPU 1-1, a CRT display 71, a magnetic tape device 72 and a magnetic disk device 73. When signal measurements based on a series of pulse sequences to be described later are repeatedly performed a plurality of times and the resulting sampling data are supplied to the signal processing unit, this signal processing unit executes the processes of Fourier transformation and image reconstruction and displays the signal intensity distribution of a section as imaged.

In the present embodiment, measurements are repeated while the amplitude of the gradient $G_X$ is being changed (in general, however, the period of time of application may well be changed with the intensity held constant), thereby to obtain the sampling data necessary for the imaging of the object. When the data are subjected to the two-dimensional Fourier transformation with respect to the gradients $G_X$ and $G_Y$, a two-dimensional image as desired can be obtained.

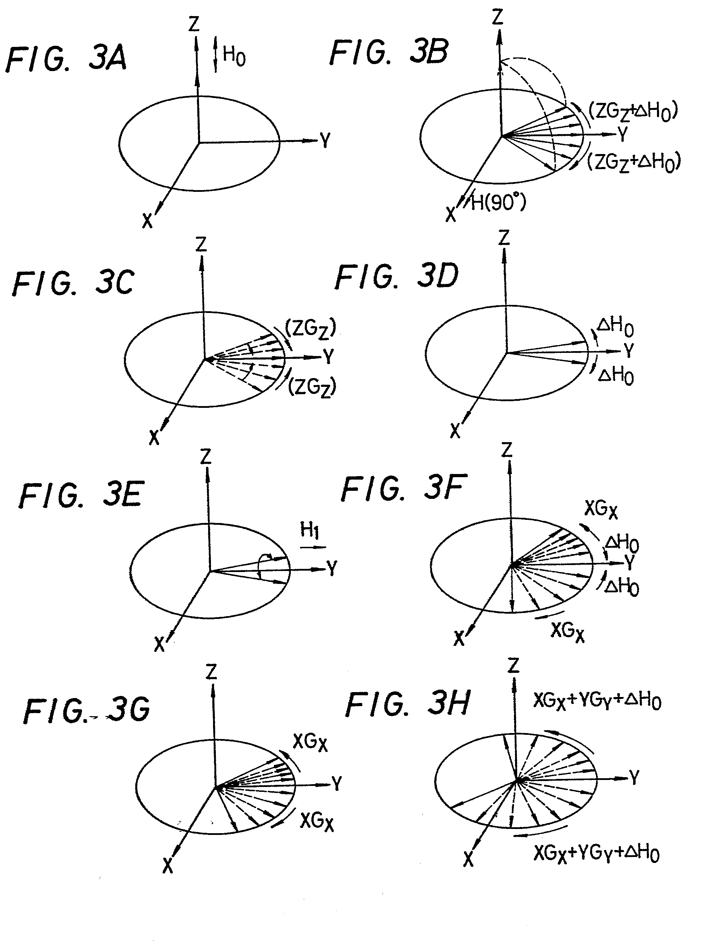

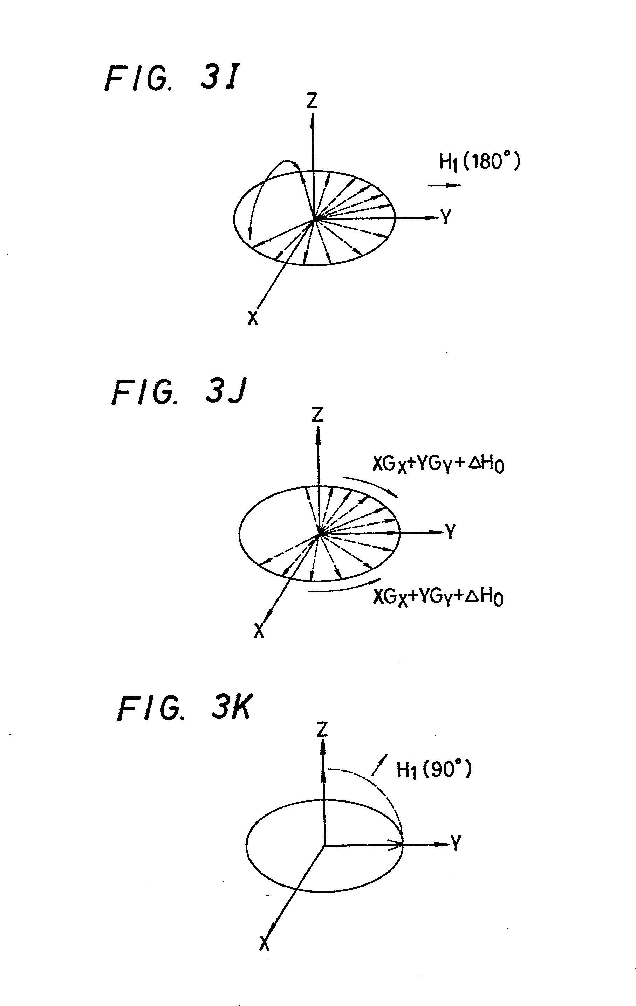

Further, the embodiment is contrived so that the degradation of image quality ascribable to the spatial inhomogeneity of the RF pulses may be corrected. This will be obvious by supposing a case where, in Figs. 3A - 3K, the gyration angle of a magnetization vector owing to RF pulses shifts at a fixed rate at all times.

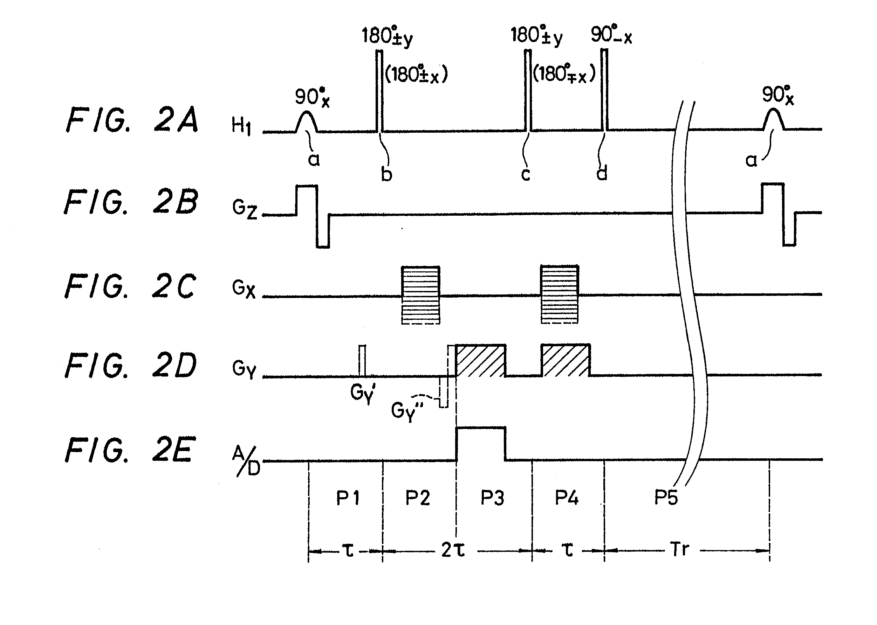

Referring now to both Figs. 2A - 2E and Figs. 3A - 3K, the pulse sequence of the present embodiment will be described. In this example, the case of obtaining the two-dimensional image of the object will be mentioned, and the pulse series premised on employing the two-dimensional Fourier transformation as the image reconstruction method will be explained. (The present invention is, of course, applicable to a pulse sequence premised on employing the projection-reconstruction method as the image reconstruction method, but the application shall not be concretely explained as it is self-evident.)

Fig. 2A shows the application sequence of an RF magnetic field $H_1$, and Figs. 2C, 2D and 2B show the gradient fields $G_X$, $G_Y$ and $G_Z$ in the directions X, Y and Z respectively. In addition, Fig. 2E shows the sampling interval of a signal. Figs. 3A - 3K show the time variation of a spin magnetization vector $M = \sum_i 2 \pi \gamma h I_i$ arising when the pulse sequence of Figs. 2A - 2E is impressed on the spin system. Here, $\gamma$ denotes a gyromagnetic ratio inherent in a nuclear spin, h Planck's constant, and $I_i$ the i-th spin. Besides, x-, y- and z-coordinates in Figs. 3A - 3K indicate such a rotating coordinate system that X-, Y- and Z-coordinates in a laboratory system are rotating round a Z-axis (the direction of a magnetostatic field) at the frequency $\omega/(2\pi)$ of an RF magnetic field.

When the object to be handled is placed in the magnetostatic field $H_0$, it is magnetized in the direction of the magnetostatic field with a longitudinal relaxation time $T_1$ peculiar thereto as a time constant, and the magnetization vector M is formed (Fig. 3A). In order to measure the magnitude of the vector M (spin density) within a two-dimensional plane where the object exists $(Z = Z_o \pm \Delta Z)$, a band-limited RF pulse $90°_x$ of predetermined phase shown at a in Fig. 2A and the gradient field pulse $G_Z$ are impressed in combination at the beginning of the interval Pl in Figs. 2A - 2E, to selectively excite the nuclear spin within the two-dimensional plane. At this time, magnetization vectors at various positions in the two-dimensional plane have precessional frequencies unequal to one another due to $G_Z$ and a magnetostatic field inhomogeneity $\Delta H_o$ within the two-dimensional plane. As shown in Fig. 3B, therefore, the magnetization vector M involves dephasing based on $G_Z$ and $\Delta H_o$ when it has fallen down to the xy-plane. Accordingly, $G_Z$ is properly inverted after the selective excitation, whereby the dephasing concerning $G_Z$ can be canceled as shown in Fig. 3C. The dephasing concerning $\Delta H_o$, however, remains as shown in Fig. 3D. To the end of canceling it, a wide-band RF $180°_y$ pulse or $180°_{-y}$ pulse which shifts in phase by 90 ° from the aforementioned $90°_x$ is impressed after a time $\mathcal{T}$ (b in Fig. 2A). Thus, the magnetization vector M gyrates by 180 ° about the y-axis within the xy-plane as shown in Fig. 3E. Since the direction of the precession is invariable, the magnetization vectors begin to converge after the impression of the $180°_{\pm y}$ pulse b, and the state in which the phases of all the magnetization vectors are uniform can be established after the time $\tau$. In case of executing the imaging, however, in order to recognize spatial information in the X direction, $G_X$ is applied in the interval P2 in Figs. 2A - 2E thereby to store the spatial information in the X direction into the magnetization vector as phase information (Fig. 3F). Thereafter, spatial information in the Y direction is obtained in such a way that an echo signal is observed while $G_Y$ is kept impressed upon lapse of a further time $\tau$ after the impression of the $180°_{\pm y}$ pulse b in Fig. 2A, thereby to continuously observe phase differences attributed to $G_Y$ (Figs. 2A - 2E; interval P3, Fig. 3H). On this occasion, the dephasing attributed to $\angle H_o$ is just canceled at the beginning of the interval P3 (Fig. 3G).

The operations up to this point of time form a measurement method having hitherto been employed. In the case of the prior art, until the next measurement is performed, the state of Fig. 3A in which the spin system is sufficiently magnetized is awaited without applying anything to the spin system. The wait time needs to be the longitudinal relaxation time $T_1$ of the object or so, and it is a period of time one or more orders longer than the aforementioned measurement time $3\bar{\tau}$. In the prior-art apparatus, accordingly, the greater part of a scan time is dissipated here. In contrast, in the apparatus of the present embodiment, for the purpose of canceling the dephasing of the magnetization vector based on $G_X$, $G_Y$ and $\angle H_o$ as effectively caused before the end of the interval P3, a 180° pulse (c in Fig. 2A) inphase with the pulse b in Fig. 2A is applied the period of time $\tau$ after the point of time at which the signal measurement has been started (Fig. 3I), whereupon $G_X$ and $G_Y$ are applied in the interval P4 so that the product of (amplitude of the field gradient) x (application period of time) may equalize to the product in the case of the gradient fields $G_X$ and $G_Y$ respectively impressed in the intervals P2 and P3. As a result, the dephasing of the magnetization vector ascribable to $G_X$, $G_Y$ and $\angle H_o$ having arisen in order to obtain the spatial information is entirely canceled at the point of time of the end of the interval P4 (Fig. 3J). Accordingly, a wide-band RF 90°$_{-x}$ pulse (d in Fig. 2A) opposite in phase to the 90°$_x$ pulse at a in Fig. 2A is impressed at this point of time, whereby all the magnetization vectors at the various positions within the two-dimensional plane can be simultaneously flipped back in the direction of the magnetostatic field (Fig. 3K).

Subsequently, after the time $T_r$ of the interval P5 in Figs. 2A - 2E has lapsed, a pulse sequence similar to that in the intervals P1 - P4 is repeated again. As stated before, the present embodiment utilizes the Fourier Zeugmatography method in which measurements are repeated with the amplitude of $G_X$ changed. That is, the measurements of spin signals as based on the pulse sequence of the intervals P1 - P4 are repeatedly performed $\underline{n}$ times (where $\underline{n}$ denotes the number of elemental areas in the direction X) while the pulse height of $G_X$ is successively changed.

Herein, the magnetization vector M is flipped back in the direction of the magnetostatic field as shown in Fig. 3K at the point of time of the end of the interval P4 in Figs. 2A - 2E, so that the magnetization vector of considerable magnitude is prepared in the direction of the magnetostatic field at this point of time. Accordingly, the wait time $T_r$ between the successive repeated sequences can be rendered much shorter than in the prior art. That is, the period of time (scan time) for repeating the plurality of times of measurements in order to obtain one image can be remarkably shortened in comparison with that of the prior-art apparatus of the same type.

Another pulse sequence which can shorten the scan time owing to a contrivance similar to that of the pulse
sequence in the above embodiment is indicated within
parentheses in Fig. 2A. In this example, a wide-band
180° pulse inphase with or opposite in phase to the
band-limited $90°_x$ pulse $\underline{a}$, that is, a wide-band $180°_{\pm x}$
pulse is used as the pulse $\underline{b}$, and a wide-band 180° pulse
opposite in phase to the $180°_{\pm x}$ pulse $\underline{b}$, that is, a
$180°_{\mp x}$ pulse is used as the pulse $\underline{c}$.

Further, in the foregoing embodiments, the wide-
band pulses have been used as the 180° pulses and the
last 90° pulse $\underline{d}$. However, when the RF pulses and the
pulse sequence are properly contrived, it is also possible
to employ only band-limited RF pulses.

In the foregoing embodiments, the gradient field
pulses have been illustrated, as rising rapidly without
considering the switching time of the rise. In actuality,
however, transient response is involved in the rise.
A method of impressing the gradient field pulse $G_Y$ as
indicated by broken lines in Fig. 2D can avoid the transient
response at the rise from adversely affecting the signal
measurement. With this method, the gradient field pulse
is caused to rise before the beginning of the interval
P3 which is the start time of the signal measurement.
In order to cancel the advanced phase component of $G_Y$,
either a gradient field pulse $G_Y'$ or $G_Y''$ is applied beforehand

As described above, the present invention is so constructed that gradient magnetic fields and an RF magnetic field after a signal measurement are applied so as to bring the phases of magnetization vectors into agreement and that when the phases have agreed, the magnetization vectors are forcibly flipped back in the direction of a magnetostatic field (spin flip-back). Unless the above purport is departed from, the invention can be realized in various aspects. Strictly speaking, a signal amplitude to be thus obtained depends upon the longitudinal relaxation time $T_1$ and transverse relaxation time $T_2$ of a spin system, the time interval $\mathcal{C}$ between a 90° pulse and a 180° pulse, and a wait time $T_r$. It is possible, however, to obtain a signal approximately equal to a spin density by properly selecting $\mathcal{C}$ and $T_r$.

As set forth above, according to the present invention, a signal having once decayed is created again by the principle of spin flip-back, thereby making it possible to conspicuously shorten the wait time of measurement. This method can remarkably shorten the scan time of the present-day NMR-CR and can produce an NMR image of high resolution and excellent image quality, and is greatly effective in that diagnoses can be rendered efficient.

Claims:

1. An NMR imaging apparatus wherein a magnetostatic field, a gradient magnetic field and an RF magnetic field as predetermined are applied to an object (91) so as to detect a nuclear spin signal of the object, and while the gradient magnetic field is being changed, the detecting operations are repeated so as to obtain information, characterized by comprising as means to apply the RF magnetic field, means (33, 61) to apply after the detection of the nuclear spin signals RF and gradient magnetic fields for rendering phases of the nuclear spin signals of the object (91) uniform and an RF pulse magnetic field for flipping back the nuclear spin signals of the uniform phases into a sense of the magnetostatic field ($H_o$).

2. The apparatus of claim 1, wherein said means to apply the RF magnetic field applies a pulse magnetic field sequence of $90°_x - \tau - 180°_{\pm y} - 2\tau - 180°_{\pm y} - \tau - 90°_{-x}$ (where $\tau$ indicates a predetermined period of time).

3. The apparatus of claim 1, wherein said means to apply the RF magnetic field applies a pulse magnetic field sequence of $90°_x - \tau - 180°_{\pm x} - 2\tau - 180°_{\mp x} - \tau - 90°_{-x}$ (where $\tau$ indicates a predetermined period of time).

# FIG. 1

FIG. 2A  H₁

FIG. 2B  G_Z

FIG. 2C  G_X

FIG. 2D  G_Y

FIG. 2E  A/D

FIG. 3A

FIG. 3B

FIG. 3C

FIG. 3D

FIG. 3E

FIG. 3F

FIG. 3G

FIG. 3H

0153703

4/4

0153703

## FIG. 3I

$H_1 (180°)$

## FIG. 3J

$XG_X + YG_Y + \Delta H_0$

$XG_X + YG_Y + \Delta H_0$

## FIG. 3K

$H_1 (90°)$